# EUROPÄISCHE PATENTSCHRIFT

(11) **EP 0 666 647 B1**
(45) Veröffentlichungstag und Bekanntmachung des Hinweises auf die Patenterteilung: **19.09.2001**
(21) Anmeldenummer: 95810023.2
(22) Anmeldetag: 13.01.1995
(51) Int. Cl.: H03K 17/10, H03K 17/08

(54) **Verfahren und Schaltungsanordnung zur Ansteuerung von Halbleiterschaltern einer Reihenschaltung**
Method and circuit arrangement for the control of semiconductor switches in a series configuration
Procédé et circuit pour commander des commutateurs semi-conducteurs montés en série

(30) Priorität: 08.02.1994 DE 4403941
(43) Veröffentlichungstag der Anmeldung: 09.08.1995
(73) Patentinhaber: ABB Industrie AG, 5400 Baden (CH)
(72) Erfinder: Dittrich, Andreas, CH-8048 Zürich (CH)
(74) Vertreter: ABB Patent Attorneys

(56) Entgegenhaltungen:
- EP-A- 0 202 962
- EP-A- 0 288 421
- EP-A- 0 288 422
- EP-A- 0 575 131
- DE-A- 2 519 396
- DE-A- 2 852 943
- US-A- 3 943 427
- ELEKTRONIK, Bd. 37, MUNCHEN DE, Seite 101 L.LORENZ ET AL. 'MOS-Module: Effektive Leistungs-Halbleiterschalter bei hohen Taktfrequnzen'
- PATENT ABSTRACTS OF JAPAN vol. 17 no. 453 (E-1417) ,19.August 1993 & JP-A-51 002571 (TOSHIBA CORP)
- PATENT ABSTRACTS OF JAPAN vol. 7 no. 123 (E-178) ,27.Mai 1983 & JP-A-58 043175 (HITACHI SEISAKUSHO K.K.)

## Beschreibung

Die Erfindung bezieht sich auf ein Verfahren zur Ansteuerung von Halbleiterschaltern einer Reihenschaltung gemäß dem Oberbegriff des Patentanspruchs 1 sowie auf eine Schaltungsanordnung zur Durchführung dieses Verfahrens.

Es ist allgemein bekannt, daß Halbleiterschalter - solche wie Leistungstransistoren, MOSFET-Tranistoren, IGBT's (Insulated Gate Bipolar Transistor) und GTO's (Gate-Turn-Off-Thyristor) - eine begrenzte maximale Sperrspannung aufweisen. Falls höhere Spannungen geschaltet werden, ist es erforderlich, die Halbleiterschalter seriell zu verbinden. Dabei übersteigt die geschaltete Gleichspannung die maximal zugelassene Spannung eines jeden der seriell geschalteten Halbleiterschalter. Demzufolge muß eine Schutzvorrichtung dafür sorgen, daß unabhängig vom Betriebszustand die maximale zugelassene Spannung an jedem Halbleiterschalter nicht überschritten wird. Dies ist dann der Fall, wenn sich die Gleichspannung gleichmäßig über die einzelnen geöffneten Halbleiterschalter aufteilt. Eine gleichmäßige oder symmetrische Spannungsverteilung über den ausgeschalteten Halbleiterschaltern wird im stationären Betrieb üblicherweise durch Symmetrierungswiderstände erzielt.

Im dynamischen Betrieb, d.h. während eines Ein- bzw. Ausschaltvorganges, ist die symmetrische Spannungsaufteilung über den Halbleiterschaltern nur dann gewährleistet, wenn das Schaltverhalten der einzelnen Halbleiterschalter gleich ist. Es ist allerdings bekannt, daß das Schaltverhalten bzw. die Ein- und Ausschaltverzögerung der einzelnen Halbleiterschalter unterschiedlich ist. Die ungleichen Ein- und Ausschaltzeiten verändern sich außerdem mit der Zeit und in Abhängigkeit von der Temperatur. Das führt dazu, daß ein gleich schnelles Ein- bzw. Ausschalten der einzelnen Halbleiterschalter in allen Betriebspunkten nicht gewährleistet ist. So übernimmt der schnellere Halbleiterschalter eine höhere Spannung während des Ausschaltens, weil der langsamere Halbleiterschalter noch leitend ist. Demzufolge kann die maximale Sperrspannung U_{cmax} des schnellsten Halbleiterschalters überschritten werden, so daß er zerstört wird. Der gleiche Zustand stellt sich auch bei einem unsymmetrischen Einschalten der Halbleiterschalter ein. In diesem Fall übernimmt der langsamste Halbleiterschalter die volle Spannung, weil alle übrigen Halbleiterschalter bereits eingeschaltet sind und niedrigere Spannung aufnehmen.

Aus der Druckschrift JP-A- 55-033313 ist eine Schaltungsanordnung zur Ansteuerung- von seriell geschalteten Halbleiterschaltern bekannt, bei der die Symmetrierung des Schaltverhaltens durch eine individuelle Verschiebung der Schaltbefehle der einzelnen Halbleiterschalter gewährleistet wird. Dabei bekommt der schnellste Halbleiterschalter seine Steuerimpulse mit einer maximalen Verzögerung und der langsamste Halbleiterschalter bekommt die Steuerimpulse sofort, so daß alle Halbleiterschalter schließlich gleichzeitig schalten.

Die in der Druckschrift EP-A-0202962 beschriebene technische Lösung schlägt weiter vor, die individuelle Verschiebung der Schaltbefehle der einzelnen Halbleiterschalter meßtechnisch zu bestimmen, indem z.B. die tatsächlichen Transistoren-Schaltflanken gemessen werden und daraus die erforderliche Schaltverzögerung ermittelt wird. Diese Lösung ist jedoch bei IGBTs wegen der extrem kurzen Verzögerungszeiten, die meßtechnisch nur ungenau zu erfassen sind, praktisch nicht anwendbar.

Aus der Druckschrift EP-B1-0288422 ist des weiteren die Lehre zu entnehmen, die stationären Spannungen des Halbleiterschalters zu messen und auf einen vorgegebenen Sollwert durch Verschiebung der Schaltflanken zu regeln. Dabei wird so verfahren, daß wenn die Halbleiterspannung bei der letzten Abschaltung zu groß war, die nächste Abschaltflanke von einem Regler verzögert wird. War die Spannung des vorhergehenden Abschaltens zu niedrig, so wird die Abschaltflanke zu einem früheren Zeitpunkt verschoben.

Ein Problem der letzten beiden Lösungen besteht darin, daß die ersten Abschaltungen unkompensiert erfolgen, weil die individuelle Verzögerungszeit des jeweiligen Halbleiterschalters erst aufgebaut werden muß. Die bekannten Schaltungsanordnungen bzw. die bei diesen zur Ansteuerung der Halbleiterschalter verwendeten Verfahren können demnach nur unter der Bedingung verwendet werden, daß die ersten Abschaltungen bei einer reduzierten Gleichspannung erfolgen, so daß die entsprechende Regelvorrichtung das Schaltverhalten angleichen kann, bevor die volle Betriebsspannung bzw. der volle Betriebsstrom aufgebaut ist. Neben dieser Einschränkung besteht ein weiteres Problem im Zusammenhang mit dem Schutz der Halbleiterschalter bei Ausfall oder Störung der Regelungseinrichtung für die Spannung. Diesbezüglich gibt es bislang keine brauchbare Lösung.

Aus dem Stand der Technik ist auch ein Verfahren zum Schutz seriell geschalteter Halbleiterschalter gemäß dem Oberbegriff des Patentanspruchs 1 bekannt, zu dessen Durchführung einem jeden Halbleiterschalter eine Spannungsbegrenzungsvor-richtung zugeordnet ist. Bei hohen Spannungen am Halbleiterschalter, die einen bestimmten Wert überschreiten und dadurch die Spannungsbegrenzungsvor-richtung aktivieren, fließt durch die Spannungsbegrenzungs-vorrichtung ein großer Strom bei einer hohen Spannung. Dabei entstehen in der Spannungsbegrenzungsvorrichtung impulsartige elektrische Verluste, die bei sich immer wieder wiederholenden Schaltvorgängen die Lebensdauer der Spannungsbegrenzungsvorrichtung erheblich verkürzen.

Aufgabe der Erfindung ist es, ein Verfahren und eine Schaltungsanordnung zur Ansteuerung von Halbleiterschaltern einer Reihenschaltung zu schaffen, durch welche die Halbleiterschalter in jedem Betriebszustand zuverlässig und in einfacher Weise geschützt sind.

Diese Aufgabe wird durch die Merkmale des Patentanpruchs 1 gelöst. Die Verlustleistungen der den einzelnen Halbleiterschalter zugeordneten Spannungsbegrenzungsvorrichtungen werden durch eine Regeleinrichtung erfaßt, welche modifizierte Steuerimpulse für jeden Halbleiterschalter aus einem gemeinsamen Steuerimpuls erzeugt, mittels dieser modifizierten Steuerimpulse die Spannungsaufteilung über die Halbleiterschalter vergleichmäßigt und dadurch gleichzeitig die Verlustleistung der Spannungsbegrenzungsvorrichtungen auf ein Minimum regelt.

Bei dem erfindungsgemäßen Verfahren wird der gemeinsame Steuerimpuls in der Weise modifiziert, daß er durch die Regeleinrichtung solange verschoben wird, bis die jeweilige Spannungsbegrenzungsvorrichtung nicht mehr anspricht. Infolgedessen wird das Schalten der Halbleiterschalter symmetrisch und die Halbleiterspannungen bleiben unter der Ansprechspannung der entsprechenden Spannungsbegrenzungsvorrichtungen. Da die Ansprechspannung der einzelnen Spannungsbegrenzungsvorrichtungen nicht ständig überschritten wird, steigt die Lebensdauer ihrer Bauelemente. Somit wird erfindungsgemäß ein kombinierter Schutz der Reihenschaltung gewährleistet, indem der entsprechende Halbleiterschalter zunächst mittels der passiven Spannungsbegrenzungsvorrichtung und anschließend die Spannungsbegrenzungsvorrichtung selbst mittels der entlastenden Regelung vor Überlast geschützt werden. Dadurch wird die Funktion der seriell geschalteten Halbleiterschalter in jedem Betriebszustand gewährleistet. Bei sehr schnellen Störungen oder beim Ausfall der Regeleinrichtung wird die Schutzfunktion durch die jeweilige passive Spannungsbegrenzungsvorrichtung übernommen. Langsame Änderungen des Schaltverhaltens der Halbleiterschalter oder Umsymmetrieren werden durch die oben beschriebene aktive Regelung ausgeregelt und dadurch die Spannungsbegrenzungsvorrichtung enlastet.

Durch das erfindungsgemäße Verfahren wird ermöglicht, Halbleiterschalter wie IGBT's oder Transistoren mit unterschiedlichen Schaltzeiten und ohne Vorauswahl seriell zu schalten. Ein weiterer Vorteil der Erfindung besteht darin, daß die Schaltungsanordnung durch kleine und preiswerte Bauelemente als Spannungsbegrenzungsvorrichtungen mit kleiner Verlustleistung wie Zenerdioden oder Varistoren realsiert werden kann. Gleichzeitig steigt die Lebensdauer der Schaltungsanordnung, weil die Bauelemente der Spannungsbegrenzungsvorrichtung entlastet werden. Das erfindungsgemäße Verfahren ermöglicht außerdem im Hochspannungsbereich die vorteilhafte Anwendung schnell schaltender Halbleiterschalter - wie z.B. IGBT's.

Zur Durchführung des erfindungsgemäßen Verfahrens ist eine Schaltungsanordnung nach dem Patentanspruch 15 vorgesehen.

Vorteilhafte Weiterbildungen des erfindungsgemäßen Verfahrens und der Schaltungsanordnung zur Ansteuerung von Halbleiterschaltern einer Reihenschaltung sind in den Patentansprüchen 2 bis 14 bzw. 16 bis 18 definiert.

Die Erfindung wird im folgenden anhand von Ausführungsbeispielen unter Bezugnahme auf Zeichnungen näher erläutert.

Es zeigen:
Fig. 1 eine Schaltungsanordnung von Halbleiterschaltern einer herkömlichen Reihenschaltung;
Fig. 2 eine Einzeldarstellung der Schalter zu der Schaltungsanordnung nach Fig. 1
Fig. 3 - 12 Ausführungsbeispiele für die Schaltungsanordnung zur Durchführung des erfindungsgemäßen Verfahrens zur Ansteuerung von Halbleiterschaltern einer Reihenschaltung;

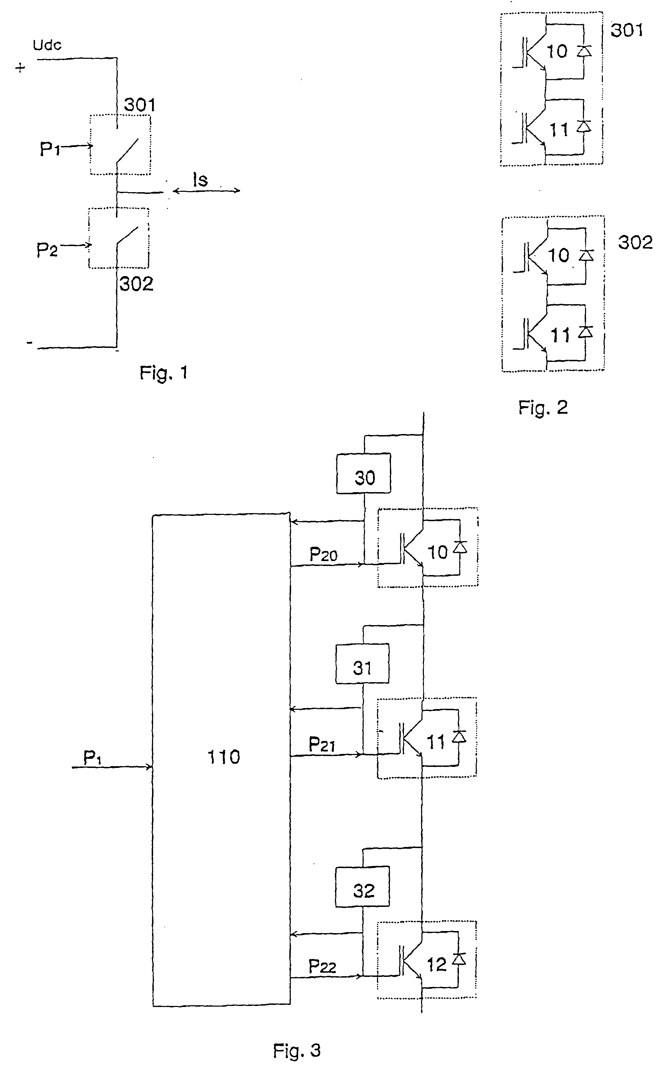

Fig. 1 zeigt eine Schaltungsanordnung von Halbleiterschaltern einer herkömlichen Reihenschaltung, nämlich eine Schalterbrücke, bei der eine Gleichspannung U_{dc} durch einen oberen Schalter 301 und einen unteren Schalter 302 moduliert wird. Wie in der Fig. 2 gezeigt ist, besteht jeder Schalter aus mindestens zwei seriell geschalteten Halbleiterschaltern 10 und 11, die hier als IGBT's mit antiparallelen Dioden ausgeführt sind. Als Halbleiterschalter können auch andere nicht einrastende Halbleiterschalter, wie z.B. Bipolar-Transistoren, dienen. Die hier verwendeten nicht einrastenden Halbleiterschalter sind dafür bekannt, daß sie nach dem Einschalten durch einen kleinen Steuerstrom abgeschaltet werden.

Gemäß einem ersten Ausführungsbeispiel der Schaltungsanrordnung in Fig. 3 hat diese drei seriell geschaltete Halbleiterschalter 10, 11 und 12, die zu einem der obengenannten Schaltern gehören. Zu einem jeden der nicht einrastenden Halbleiterschalter 10, 11 und 12 ist jeweils eine Spannungsbegrenzungsvorrichtung 30, 31 bzw. 32 vorgesehen, die zwischen dem Kollektor und der Steuerelektrode des Halbleiterschalters angeschlossen ist.

Alle Spannungsbegrenzungsvorrichtungen 30, 31 bzw. 32 sind meßtechnisch mit einer Regeleinrichtung 110 verbunden. Diese ist ihrerseits mit einem, in der Fig. 3 nicht gezeigten, externen Steuerimpulsgenerator verbunden, um aus einem für alle Halbleiterschalter gemeinsamen Steuerimpuls P₁ modifizierte Steuerimpulse P₂₀, P₂₁ und P₂₂ für die einzelnen Halbleiterschalter zu erzeugen. Die Schaltungsanordnung in Fig. 3 funktioniert in der nachfolgend beschriebenen Weise.

Wenn z.B. die am Halbleiterschalter 10 einwirkende Spannung einen bestimmten Grenzwert überschreitet, so fließt durch die entsprechende Spannungsbegrenzungsvorrichtung 30 ein Strom. Die dabei entstehende Verlustleistung in der Spannungsbegrenzungsvorrichtung 30 wird durch die Regeleinrichtung 110 erfaßt bzw. gemessen, die entsprechend dieser gemessenen Verlustleistung den gemeinsamen Steuerimpuls P₁ durch Verzögerung zu einem modifizierten Steuerimpuls P₂₀ abändert. Dieser Vorgang läuft in der selben Weise so auch in bezug auf die restlichen Halbleiterschalter 11 und 12 ab, so daß im Ergebnis die Spannungsaufteilung über alle Halbleiterschalter 10, 11, und 12 vergleichmäßigt wird. Durch diese Symmetrierung der Spannungsverteilung über die Halbleiterschalter wird selbst die Verlustleistung der Spannungsbegrenzungsvorrichtungen 30, 31 und 32 auf ein Minimum regelt.

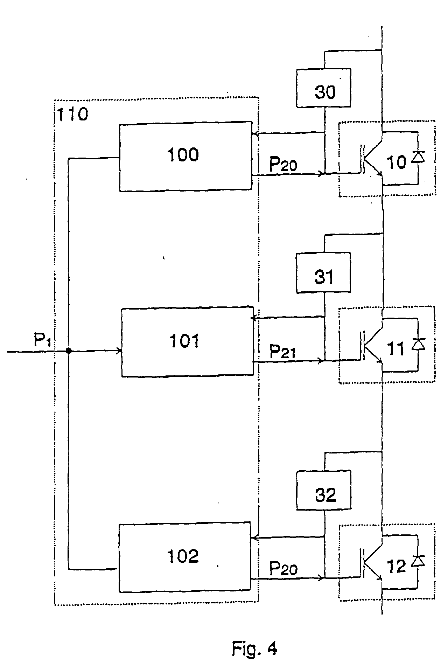

Gemäß dem in Fig. 4 gezeigten zweiten Ausführungsbeispiel der Schalteranordnung besteht die Regeleinrichtung 110 aus drei selbständigen Regelvorrichtungen 100, 101 und 102, die den entsprechenden Halbleiterschaltern 10, 11, und 12 zugeordnet sind.

Als Maß für die von der Regeleinrichtung 110 bzw. von den einzelnen Regelvorrichtungen 100, 101 und 102 zu erfassende Verlustleistung der Spannungsbegrenzungsvorrichtungen 30, 31 und 32 können verschiedene Größen verwendet werden. Als eine solche Größe kann z.B. die Zeitfläche des Stromes durch die jeweilige Spannungsbegrenzungsvorrichtung erfaßt werden. Diese Zeitfläche ergibt multipliziert mit der Spannung der Spannungsbegrenzungsvorrichtung die Verlustenergie und ist somit proportional der Verlustleistung der Spannungsbegrenzungsvorrichtung bei einer bestimmten Schaltfrequenz. Weil die Ansprechspannung der Spannungsbegrenzungsvorrichtung konstant ist, ist die Stromzeitfläche representativ für die Verlustleistung.

Die für die Verlustleistung representative Zeitfläche des Stromes ist selbst proportional zu der Amplitude des Stromes und zu der Dauer des Stromflusses in der Spannungsbegrenzungsvorrichtung. Demnach kann durch die Regeleinrichtung bzw. -vorrichtung nur die Amplitude des Stromes I_{S} durch die Halbleiterschalter 10, 11 und 12 erfaßt werden, weil die Amplitude somit proportional zu der Verlustleistung der Spannungsbegrenzungsvorrichtung ist. Eine solche Verfahrensweise ist besonders gut geeignet für eine binäre Auswertung der Verlustleistung der Spannungsbegrenzungsvorrichtung. Für die Realisierung eines binären Amplitudenmeßgliedes in der Regeleinrichtung bzw. -vorrichtung wird nur ein Komparator gebraucht, der beim Überschreiten eines bestimmten Amplitudenwertes einen Impuls (I-Puls) generiert. Ein binäres Stromflußdauer-Meßglied erzeugt einen Impuls mit konstanter Länge (I-Puls), der das Vorhandensein eines Stromes in der Spannungsbegrenzungsvorrichtung angibt.

Durch die Regeleinrichtung bzw. -vorrichtung kann aber auch nur die Dauer des Stromes I_{S} durch die Halbleiterschalter 10, 11 und 12 erfaßt werden, weil auch die Dauer proportional zu der Verlustleistung der Spannungsbegrenzungsvorrichtung ist. Für die Realisierung eines Stromflußdauer-Meßgliedes in der Regeleinrichtung bzw. -vorrichtung wird nur ein Komparator gebraucht, der während des Stromflusses durch die Spannungsbegrenzungsvorrichtung einen Impuls generiert. Die Länge des Impulses ist dabei proportional zu der entstehenden Verlustleistung.

Die Temperatur der Elemente der Spannungsbegrenzungsvorrichtung ist auch representativ für die Verlustleistung der letzteren. Diese Temperatur kann elektronisch erfaßt und als Basis für die Regelung genutzt werden, wobei allerdings die thermische Zeitkonstante dieser Elemente zu berücksichtigen ist.

Unabhängig von der Art der verwendeten Halbleiterschalter kann bei allen Ausführungsbeispielen der Schaltungsanordnung parallel zu einem jeden Halbleiterschalter ein Snubber zur Begrenzung der Spannungsspitzen bei der Abschaltung des Halbleiterschalter-Stromes geschaltet werden.

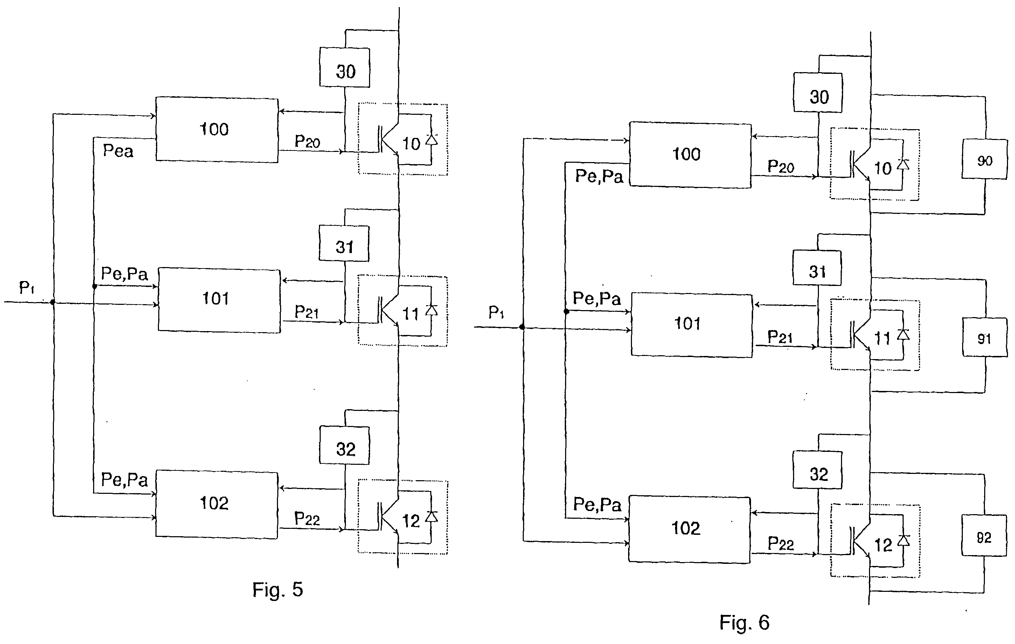

Bei dem in Fig. 5 gezeigten vierten Ausführungsbeispiel der Schaltungsanordnung ist die erste Regelvorrichtung 100 mit den übrigen Regelvorrichtungen 101 und 102 gekoppelt. Der Halbleiterschalter 10, zu dem die erste Regelvorrichtung 100 gehört dient als Referenzschalter bzw. Master, wobei die übrigen Halbleiterschalter 31 und 32 als Slaves zu bezeichnen sind. Durch diese Schaltungsanrordnung wird folgende Verfahrensweise gewährleistet: Die Regelvorrichtung 100 des Masters 10 verschiebt bzw. verzögert den gemeinsamen Steuerimpuls P₂₀ um einen konstanten Anfangszeitwert, der größer als die maximalen Unsymmetriezeiten des Halbleiterschalters 10 und der Signalelektronik ist. Die gleiche Verzögerung wird als Anfangswert der Steuerimpulse P₂₁ und P₂₂ der Slaves 11 und 12 geladen. Die Regelvorrichtung 100 verändert nicht die Anfangswerte der Impulsverschiebung des Masters 10. Die Regelvorrichtungen 101 und 102 der Slaves 11 und 12 verschieben die Steuerimpulse P₂₁ und P₂₂ der Slaves 11 so, daß die Verlustleistungen der Spannungsbegrenzungsvorrichtungen 31 und 32 auf ein Minimum bzw. auf Null geregelt werden. Wenn der Master 10 zu langsam ausschaltet und dabei die Spannungsbegrenzungsvorrichtung 30 eingreift, so erzeugt die Regelvorrichtung 100 das Signal Pₐ, welches die Verlustleistung der Spannungsbegrenzungsvorrichtung 30 beim Ausschalten angibt. Das Signal Pₐ wird zu den übrigen Regelvorrichtungen 101 und 102 geleitet und führt bei diesen zu einer gleichen Vergrößerung der Impulsverzögerung der Ausschaltflanken. Dadurch wird erreicht, daß das Ausschalten des Masters 10 verglichen mit dem Ausschalten der Slaves 11 und 12 schneller wird, ohne dabei die Verzögerung des modifizierten Steuerimpulses P₂₀ am Master 10 zu verändern. Wenn der Master 10 zu schnell einschaltet und dabei die Spannungsbegrenzungsvorrichtung 30 eingreift, so erzeugt die Regelvorrichtung 100 das Signal Pₑ, welches die Verlustleistung der Spannungsbegrenzungsvorrichtung 30 beim Einschalten angibt. Das Signal Pₑ wird zu den übrigen Regelvorrichtungen 101 und 102 geleitet und führt bei diesen zu einer gleichen Verkleinerung der Impulsverzögerung der Einschaltflanken. Dadurch wird erreicht, daß das Einschalten des Masters 10 verglichen mit mit dem Einschalten der Slaves 11 und 12 langsamer wird, ohne dabei die Verzögerung des modifizierten Steuerimpulses P₂₀ am Master 10 zu verändern.

Ein in der Fig. 6 gezeigtes fünftes Ausführungsbeispiel der Schaltungsanordnung entspricht dem vorhergehenden Ausführungsbeispiel, in dem zu einem jeden der Halbleiterschalter 10, 11 und 12 jeweils ein parallel geschaltetes Kurzschlußelement 90, 91 bzw. 92 vorgesehen ist. Wenn es bei dieser Schaltungsanordnung zum Ausfall eines oder mehrerer der seriell geschalteten Halbleiterschalter 10, 11 und 12 kommt, so daß der elektrische Leitweg für den Schalterstrom I_{S} unterbrochen wird, so übernimmt das jeweilige Kurzschlußelement 90, 91 bzw. 92 den Stromfluß für eine begrenzte Zeit und verhindert dadurch, daß eine zerstörende elektrische Entladung (Lichtbogen) entsteht. Das Kurzschlußelement hat selbst eine Spannungs-Ansprechschwelle, welche größer als die Ansprechschwelle der entsprechenden Spannungsbegrenzungsvorrichtung ist. Das jeweilige Kurzschlußelement 90, 91 bzw. 92 greift erst dann ein, wenn die Spannungsbegrenzung durch die Spannungsbegrenzungsvorrichtung 30, 31 bzw. 32 und die Leistungsregelung durch die Regelvorrichtung 100, 101 bzw. 102 nicht funktioniert, weil der nicht einrastende Halbleiterschalter 10, 11 bzw. 12 ausgefallen ist und dabei den Stromfluß unterbrochen hat.

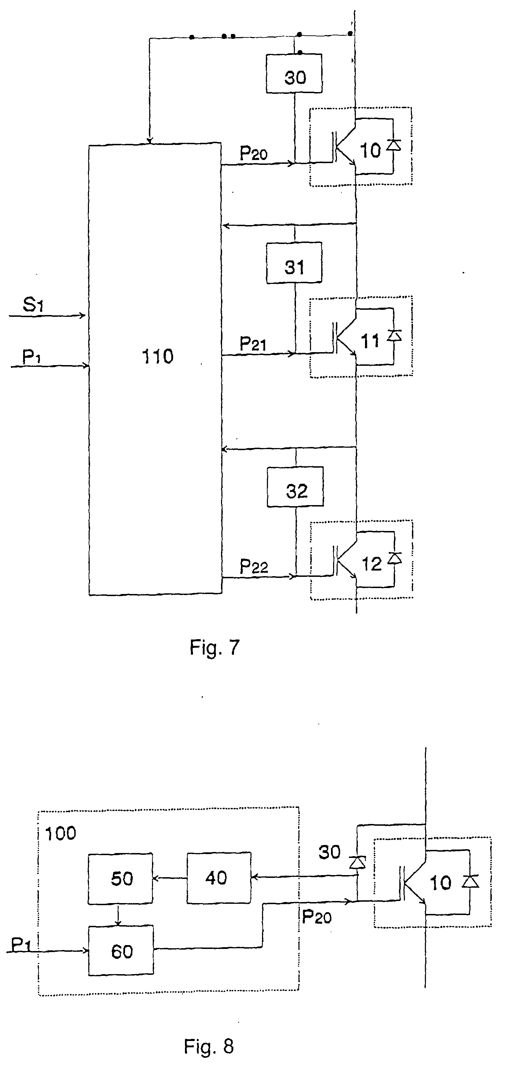

Bei einem in Fig. 7 gezeigten sechsten Ausführungsbeispiel der Schaltungsanordnung werden durch die für alle Halbleiterschalter 10, 11 und 12 gemeinsame Regeleinrichtung 110 modifizierte Steuerimpulse P₂₀, P₂₁ und P₂₂ erzeugt. Durch diese Steuerimpulse wird die Spannung eines jeden Halbleiterschalters einem Spannungssollwert S₁ angeglichen, welcher kleiner als die Ansprechspannung der jeweiligen Spannungsbegrenzungsvorrichtung ist. Da der Spannungsregler 110 die Halbleiterschalter-Spannung auf einen Sollwert S₁ regelt, der kleiner als die Ansprechspannung der Spannungsbegrenzungsvorrichtungen ist, sprechen die Spannungsbegrenzungsvorrichtungen im Dauerbetrieb nicht an. Nur so lange die Spannungsregelung noch nicht die Unsymmetrien durch Flankenverschiebung des Impulses P₁ korrigiert hat, greifen die Spannungsbegrenzungsvorrichtungen 30, 31, 32 ein. Der Ausregelvorgang dauert nur einige Schaltperioden. Dieses Verfahren bietet daher einen indirekten Schutz der Spannungsbegrenzungsvorrichtungen. Die Voraussetzung dafür ist, daß der Spannungssollwert S₁ genügend kleiner als die Ansprechspannung der Spannungsbegrenzungsvorrichtungen ist.

Ein in Fig. 8 dargestelltes siebtes Ausführungsbeispiel zeigt einen möglichen Aufbau der Regelvorrichtung 100, der analog auch bei den übrigen Halbleiterschalter Anwendung finden kann. Diese Schaltungsanordnung hat eine als Zenerdiode ausgeführte Spannungsbegrenzungsvorrichtung 30, die zwischen dem Kollektor und der Steuerelektrode des Halbleiterschalters 10 geschaltet ist. An der Zenerdiode 10 ist eine Verlustleistungs-Erfassungseinrichtung 40 angeschlossen, mit der das Fließen eines Stroms in der Zehnerdiode erfaßt und an einem Regler 50 mit einem Impulsverzögerer 60 gemeldet wird. Der Regler 50 bildet auf der Grundlage der an der Zenerdiode 10 gemessenen Istwerte eine Verzögerung, derentsprechend der Impulsverzögerer den externen Steuerimpuls P₁ verzögert und dadurch einen modifizierten Steuerimpuls P₂₀ bildet.

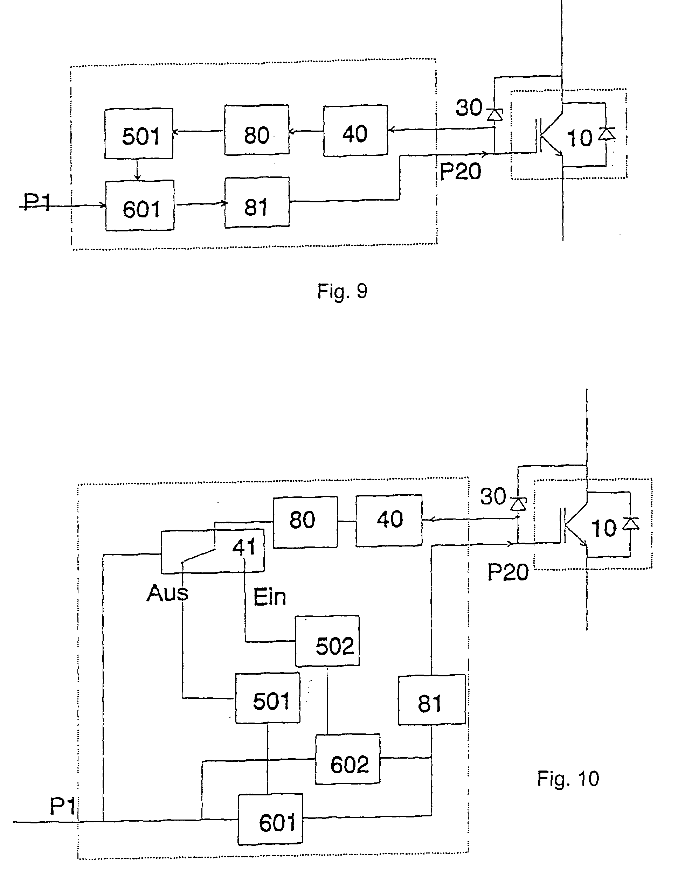

Fig. 9 zeigt eine besondere Ausführungsform der Schaltungsanordnung in Fig. 8, bei der die Erfassungseinrichtung 40 eine binäre Istwert-Erfassungseinrichtung ist. Die binäre Istwert-Erfassungseinrichtung 40 generiert je ein Impuls pro Ausschaltvorgang (I-Puls), wenn ein Strom durch die Spannungsbegrenzungsvorrichtung 30 beim Ausschalten fließt. Der I-Puls wird durch ein galvanisches Trennelement 80 (Optokoppler) zu einem digitalen Ausschalt-Regler 501 übertragen, der nach jedem I-Puls die Verzögerung für die Ausschalt-Steuerimpulsflanke um jeweils ein Zeitquantum vergrößert. Dadurch wird ein modifizierter Steuerimpuls P₂₀ gebildet, der durch ein galvanisches Trennelement 81 zum Steuereingang des Halbleiterschalters 10 gelangt.

Fig. 10 zeigt eine weitere besondere Ausführungsform der Schaltungsanordnung in Fig. 8, bei der die Erfassungseinrichtung 40 auch eine binäre Istwert-Erfassungseinrichtung ist, welche ein Impuls pro Schaltvorgang (I-Puls) generiert, falls ein Strom durch die Spannungsbegrenzungsvorrichtung beim Ausschalten fließt. Hier wird der I-Puls durch ein galvanisches Trennelement 80 zu einer Weiche 41 übertragen, die vom Steuerimpuls P₁ so gesteuert wird, daß die I-Pulse des Einschaltens zu einem digitalen Einschalt-Regler 502 und die I-Pulse des Ausschaltens zu einem digitalen Ausschalt-Regler 501 gelangen. Die Ausgänge des Einschalt-Reglers 502 bzw. des Ausschalt-Reglers 501 wirken auf jeweils einen digitalen Einschalt-Impulsverzögerer 602 und einen digitalen Ausschalt-Impulsverzögerer 601, so daß dadurch ein verzögerter Steuerimpuls P₂₀ gebildet wird. Der verzögerte Steuerimpuls P₂₀ gelangt anschließend über ein galvanisches Trennelement 81 zum Steuereingang des Halbleiterschalters 10.

In dieser Schaltungsanordnung kann zusätzlich ein binäres Spannungsmeßglied vorgesehen werden, welches das Unterschreiten eines vorgegebenen Halbleiterschalter-Spannungssollwertes nach jedem Ausschalten mit einem Impuls (U-Puls) zum digitalen Ausschaltregler 501 meldet und dadurch eine Verringerung der Verzögerung der Ausschaltflanke des zu modifizierenden Steuerimpulses P₁ gewährleistet. Dadurch wird erreicht, daß die Spannung des Halbleiterschalters diesen Wert nicht unterschreitet. Der Spannungsregler und der Verlust-Leistungsregler der Spannungsbegrenzungsvorrichtung arbeiten parallel. Falls die Halbleiterschalter-Spannung in ausgeschaltetem Zustand zu niedrig ist, so wird die Ausschalt-Impulsflanke durch den Spannungsregler verfrüht, so daß beim nächsten Abschalten die Halbleiterschalter-Spannung steigt. Falls die Halbleiterschalter-Spannung zu hoch wird, folgt ein I-Puls, welcher die Abschaltflanke weiter verschiebt und dadurch die Ausschaltspannung verringert. Der Spannungsregler und der Regler der Verlustleistung der Spannungsbegrenzungsvorrichtung arbeiten demzufolge wie eine Hystereseregelung der Spannung.

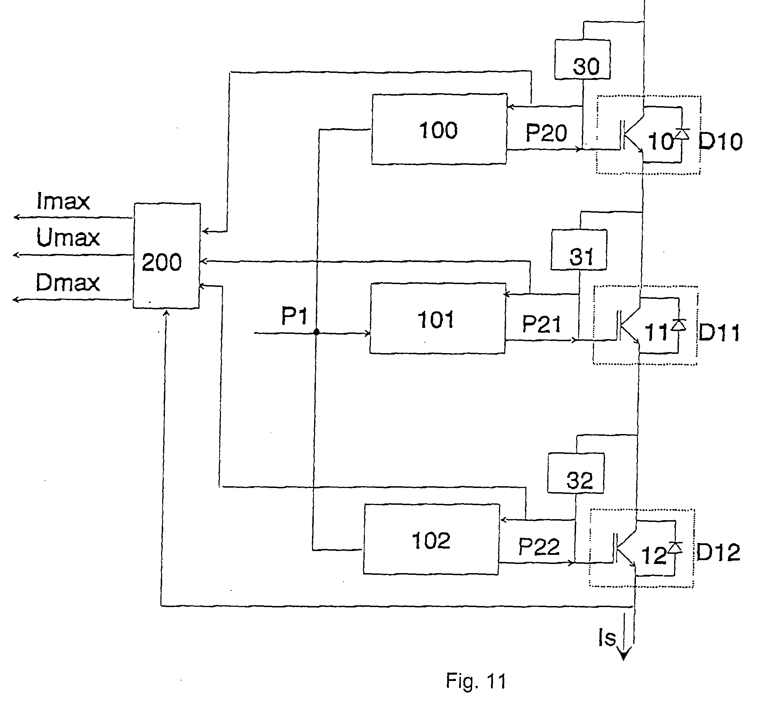

In Fig. 11 ist ein zehntes Ausführungsbeispiel gezeigt, bei dem zu der in Fig. 4 dargestellten Schaltungsanordnung zusätzlich eine Steuereinrichtung 200 vorgesehen ist. Die Steuereinrichtung 200 erfaßt die Zustände eines Überstroms, einer Überspannung und einer Dioden-Unsymmetrie bei den nachfolgend beschriebenen Betriebszuständen.

Je größer der Strom der seriell geschalteten Halbleiterschalter 10, 11 und 12 ist, desto höhere Spannungsspitzen entstehen beim Stromabschalten dieses Stroms. Wenn die Spannungsspitzen so hoch werden, daß die Ansprechspannungen der Spannungsbegrenzungsvorrichtungen- 30, 31 und 32 überschritten werden, so führen diese Spitzen während der Stromabschaltzeit zu einem Ansprechen aller Spannungsbegrenzungsvorrichtungen. Der Strom, bei dem alle Spannungsbegrenzungsvorrichtungen ansprechen, ist der maximal zugelassene Schalterstrom Iₛₘₐₓ. Die Steuereinrichtung 200 erfaßt diesen Zustand und generiert ein Überstrom-Signal Iₘₐₓ.

In bestimmten Betriebszuständen kann die angelegte Gleichspannung U_{dc} dauerhaft den maximal zugelassenen Wert U_{dcmax} überschreiten. Diese maximale Spannung teilt sich symmetrisch über die einzelnen Halbleiterschalter 10, 11 und 12 auf, wobei die Ansprechschwellen aller Spannungsbegrenzungsvorrichtungen 30, 31 und 32 überschritten werden. Dieser Zustand ist stationär, d.h. er dauert so lange, wie die maximale Spannung U_{dcmax} anliegt. Dieser Zustand, in dem kein Schalterstrom I_{S} fließt, kann nur durch das Abschalten der zu hohen Spannung Udc beendet werden. Durch einen solchen Zustand werden die Spannungsbegrenzungsvorrichtungen 30, 31 und 32 und die Halbleiterschalter 10, 11 und 12 auf Dauer zerstört.

Wenn die in Fig. 11 gezeigten Halbleiterschalter 10, 11 und 12 des oberen Schalters 301 der in Fig. 1 schematisch dargestellten Schalterbrücke eingeschaltet werden, so übernehmen diese den Strom I_{S} von den antiparallelen unteren Dioden der Halbleiterschalter des unteren Schalters 302. Die unteren Dioden schalten ungeregelt ab. Auch die Abschaltverhalten dieser Dioden weichen voneinander ab. Durch Snubber, die ähnlich den in Fig. 6 dargestellten Kurzschlußelemente 90, 91 und 92 parallel zu den Halbleiterschaltern geschaltet werden, kann das Schalten der seriell geschalteten Dioden symmetriert und somit für eine gleichmäßige Spannungsverteilung gesorgt werden. Wenn an einer Diode trotzdem Überspannung auftritt, dann greift die entsprechende Spannungsbegrenzungsvorrichtung ein und der parallel zu der betreffenden Diode angeschlossene Halbleiterschalter wird eingeschaltet, so daß der letztere leitend wird und die Diodenspannung begrenzt. Dieser Vorgang kann jedoch nicht beliebig oft wiederholt werden, weil die entsprechende Spannungsbegrenzungsvorrichtung bei jedem Ausschaltvorgang belastet wird. Die Steuereinrichtung 200 dient hier dazu, ein Dioden-Unsymmetrie-Signal Dₘₐₓ in diesem Fall zu generieren.

Die von der Steuereinrichtung 200 gelieferten Überstrom-Signal Iₘₐₓ, Überspannung-Signal Uₘₐₓ und Dioden-Unsymmetrie-Signal Dₘₐₓ können z.B. zur zusätzlichen Regelung in einer solchen Schaltungsanordnung nach Fig. 11 verwendet werden, bei der die Regelvorrichtungen gemäß Fig. 10 ausgebildet sind und zwischen der Weiche 41 und den Reglern 501, 502 ein Istwert-Filter angeschlossen ist. Der Istwert-Filter wird durch das Überstrom-Signal Iₘₐₓ bzw. durch das Überspannung-Signal Uₘₐₓ oder durch das Dioden-Unsymmetrie-Signal Dₘₐₓ so angesteuert, daß bei den oben beschriebenen Zuständen, die zu einer Generierung dieser Signale führen, die von der Erfassungsvorrichtung 40 gemessenen Istwerte des durch die entsprechende Spannungsbegrenzungsvorrichtung fließenden Stromes mittels des Istwert-Filters ausgefiltert werden.

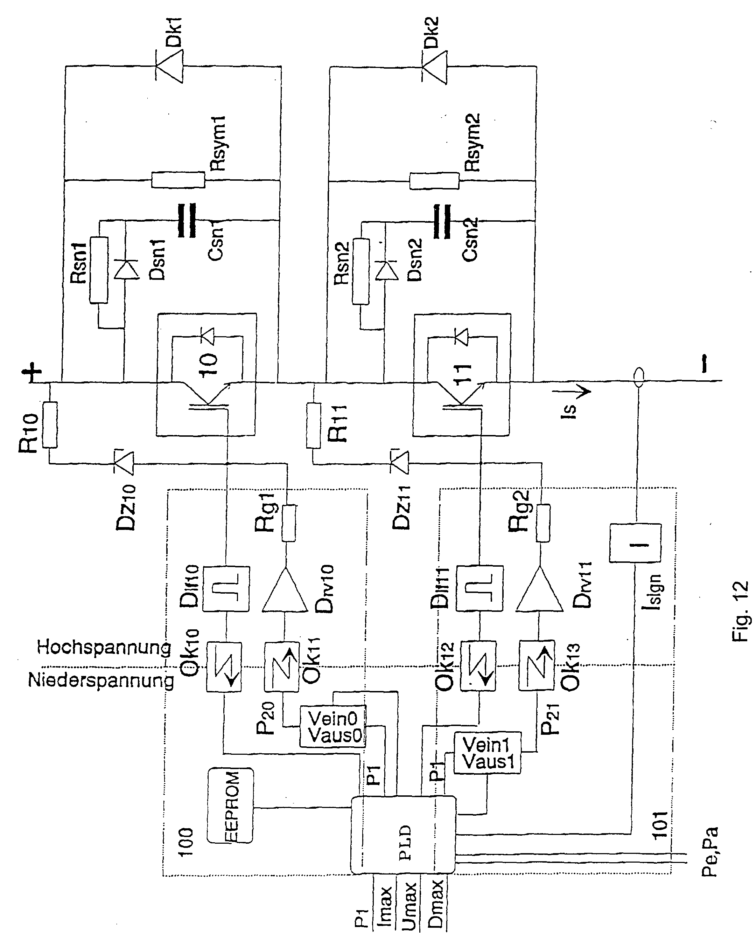

Ein konkretes Ausführungsbeispiel der Schaltungsanordnung, in der die Reihenschaltung nur zwei Halbleiterschalter mit jeweils einer Regelvorrichtung pro Halbleiterschalter aufweist, ist in Figur 12 gezeigt. Hier umfaßt ein Modul der Halbleiterschalter 10, 11 jeweils ein IGBT und eine Freilaufdiode. RCD-Snubber schützen die Module vor Überspannungsspitzen während des Abschaltens des Laststromes. Die Snubber werden durch die Elemente Rsn₁, Csn₁, Dsn₁ bzw. Rsn₂, Csn₂, Dsn₂ gebildet. Die Symmetrierungswiderstände Rsym₁, Rsym₂ sorgen für die stationäre Spannungsaufteilung der Reihenschaltung. Die Kurzschlußelemente sind als Avalanche-Dioden Dk₁, Dk₂ oder als Varistoren ausgebildet. Diese übernehmen den Stromfluß, wenn die Module ausfallen und die Modulspannung die Ansprechschwelle der Spannungsbegrenzungsvorrichtungen und die höhere Ansprechschwelle dieser Kurzschlußelemente Dk₁, Dk₂ überschreitet.

In Fig. 12 sind die Regelvorrichtung 100 eines Masters 10 und die Regelvorrichtung 101 eines Slaves 11 dargestellt. Die Spannungsbegrenzungsvorrichtungen des Masters und des Slaves sind als Zenerdiode Dz₁₀, Dz₁₁ ausgeführt. Der StromfluB durch jede Zenerdiode Dz₁₀, Dz₁₁ wird erfaßt und erzeugt je ein Impuls (I-Puls). Dafür ist der Differenzglied Dif₁₀ bzw. Dif₁₁ zuständig. Der I-Puls wird durch den Optokoppler Ok₁₀ bzw. Ok₁₂ zu der Regelvorrichtung des Masters bzw. des Slaves übertragen. Die digitalen Bestandteile der Regelvorrichtungen 100, 101 sind in einem PLD (Programable Logic Device) integriert. Die Signale Pₐ und Pₑ werden, wie im Ausführungsbeispiel gemäß Fig. 6, von der Regelvorrichtung 100 des Masters 10 erzeugt und werden weiter intern im PLD zu dem Slaveregler 101 geleitet. Zusätzlich werden diese Signale Pₐ, Pₑ aus dem PLD ausgeführt und können für die Steuerung weiterer Slave-PLDs genutzt werden. Damit können beliebig viele Slave-PLDs kaskadiert werden. Das Signal Pₑ definiert, ob die Einschaltflanken verändert werden, das Signal Pₐ gibt an, ob die Ausschaltflanken geändert werden. Das Signal Pₐ bzw. Pₑ besteht aus zwei Bit; das eine Bit zeigt an, daß die entsprechenden Flanken verfrüht werden und das zweite Bit zeigt an, daß die Flanken verspätet werden. Die gerechneten Verzögerungszeiten werden im EEPROM Electrically Erasable Programable Read Only Memory) gespeichert und bleiben nach Spannungsausfall erhalten. Die digitalisierten Verzögerungszeiten werden in den Verzögerungsbausteinen für das Ein- und Ausschalten des Masters Vₑᵢₙ₀, Vₐᵤₛ₀ und in den Verzögerungsbausteinen für das Ein- und Ausschalten des Slaves Veinl, Vₐᵤₛ₁ geladen, welche Verzögerungen im Nanosekunden-Bereich ermöglichen. Das Laden der neu gerechneten Zeiten wird vom PLD nach jedem Impuls durchgeführt. Das zentrale Steuersignal P1 wird durch die Verzögerungsglieder Vₑᵢₙ₁, Vₐᵤₛ₁, Vₑᵢₙ₀, Vₐᵤₛ₀ verzögert und die modifizierten Steuersignale P₂₀, P₂₁ werden durch die Optokoppler Ok₁₁, Ok₁₃ zu den Treibern Drv₁₀, Drv₁₁ weitergeleitet. Die verstärkten Signale gelangen über die Gatewiderstände Rg₁, Rg₂ zu den Gates der IGBTs.

Der PLD erzeugt auch die binären Signale Iₘₐₓ, falls die I-Pulse aller Spannungsbegrenzungsvorrichtungen ansprechen, während der Laststrom von den IGBTs abgeschaltet wird. Falls alle I-Pulse im stromlosen Zustand generiert werden, wird das Signal Uₘₐₓ erzeugt. Das Signal Dₘₐₓ (Diodenunsymmetrie) wird dann generiert, falls alle I-Pulse anliegen und der Laststrom I_{S} von den Freilaufdioden abgeschaltet wird, d.h. wenn der Laststrom in Fig. 12 nach Plus gerichtet ist. Der Laststrom wird durch den Stromsensor I erfaßt, welcher durch das binäre Signal I_{sign} die Stromrichtung angibt. Die Fehlerzustände, welche den Signalen Uₘₐₓ, Iₘₐₓ, Dₘₐₓ entsprechen, werden in einem Fehlerregister des PLD gespeichert. Die externe Aktivierung des Signals Reset bewirkt das Rücksetzen der Fehlerzustände und der Signale Uₘₐₓ, Iₘₐₓ und Dₘₐₓ.

## Patentansprüche

1. Verfahren zur Ansteuerung von Halbleiterschaltern (10, 11,12) einer Reihenschaltung, bei dem zur Vergleichmässigung der Spannungsaufteilung über den Halbleiterschaltern (10, 11, 12) mittels einer Regeleinrichtung (110) modifizierte Steuerimpulse ( P20, P21, P22) für jeden Halbleiterschalter (10, 11, 12) aus einem gemeinsamen Steuerimpuls (P1) erzeugt werden und ein Mass für eine Verlustleistung von Spannungsbegrenzungsvorrichtungen (30, 31, 32) erfasst wird, wobei jedem Halbleiterschalter je eine Spannungsbegrenzungsvorrichtung (30, 31, 32) zugeordnet ist, **dadurch gekennzeichnet,**
**dass** als Halbleiterschalter (10, 11, 12) nicht einrastende Halbleiterschalter verwendet werden, die Spannungsbegrenzungsvorrichtungen (30, 31, 32) zwischen Kollektor und Steuerelektrode des jeweiligen Halbleiterschalters (10, 11, 12) angeschlossen werden und die Regeleinrichtung (110) die Steuerimpulse (P20, P21, P22) für jeden Halbleiterschalter (10, 11, 12) so modifiziert, daß das Mass für die Verlustleistung auf ein Minimum geregelt wird.

2. Verfahren nach Anspruch 1, **dadurch gekennzeichnet, daß** die Regeleinrichtung (110) aus jeweils einer Regelvorrichtung (100, 101, 102) pro Halbleiterschalter (10, 11, 12) gebildet wird.

3. Verfahren nach Anspruch 1 oder 2, **dadurch gekennzeichnet, dass** die Verlustleistung der Spannungsbegrenzungsvorrichtungen (30, 31, 32) auf Null geregelt wird.

4. Verfahren nach einen der Ansprüche 1 bis 3, **dadurch gekennzeichnet, daß** die Zeitfläche des Stromes durch jede Spannungsbegrenzungsvorrichtung (30, 31, 32) als Maß für ihre Verlustleistung verwendet wird.

5. Verfahren nach einem der Ansprüche 1 bis 3, **dadurch gekennzeichnet, daß** die Amplitude des Stromes durch jede Spannungsbegrenzungsvorrichtung (30, 31, 32) als Maß für ihre Verlustleistung verwendet wird.

6. Verfahren nach einem der Ansprüche 1 bis 3, **dadurch gekennzeichnet, daß** die Dauer des Stromflußes durch jede Spannungsbegrenzungsvorrichtung (30, 31, 32) als Maß für ihre Verlustleistung verwendet wird.

7. Verfahren nach einem der Ansprüche 1 bis 3, **dadurch gekennzeichnet, daß** die Temperatur jeder Spannungsbegrenzungsvor-richtung (30, 31, 32) als Maß für ihre Verlustleistung verwendet wird.

8. Verfahren nach einem der Ansprüche 1 bis 7, **dadurch gekennzeichnet, daß** die modifizierten Steuerimpulse (P20, P21, P22) durch zeitliche Verschiebung der Schaltflanken des Steuerimpulses (P1) gebildet werden.

9. Verfahren nach einem der Ansprüche 1 bis 8, **dadurch gekennzeichnet, dass** die Regeleinrichtung (110) bzw. jede der Regelvorrichtungen (100, 101, 102) digital ist und beim Ansprechen der jeweiligen Spannungsbegrenzungsvorrichtung und Auftreten der Verlustleistung ein Impuls generiert wird und die Schaltflanken des jeweiligen modifizierten Steuerimpulses (P20, P21, P22) um ein Zeitquantum verschoben werden.

10. Verfahren nach einem der Ansprüche 1 bis 9, **dadurch gekennzeichnet, daß** ein Halbleiterschalter (10) als Referenzschalter (Master) verwendet wird, wobei die ihn ansteuernden Schaltflanken um eine konstante Zeit verzögert werden und aufgrund der gemessenen Verlustleistung der Spannungsbegrenzungsvorrichtungen (30, 31, 32) aller Halbleiterschalter die Schaltflanken der restlichen Halbleiterschalter (Slaves) (11, 12) so variiert werden, daß die Verlustleistung aller Halbleiterschalter (10, 11, 12) auf ein Minimum geregelt wird.

11. Verfahren nach einem der Ansprüche 1 bis 10, **dadurch gekennzeichnet, daß** je ein Kurzschlusselement (90, 91, 92) parallel zu je einem Halbleiterschalter (10, 11, 12) angeschlossen wird, so daß beim Überschreiten einer Ansprechschwelle des Kurzschlusselements, die höher als die Ansprecheschwelle der jeweiligen Spannungsbegrenzungsvorrichtung (30, 31, 32) ist, das Kurzschlusselement den Stromfluß vom jeweiligen Halbleiterschalter übernimmt.

12. Verfahren nach einem der Ansprüche 1 bis 11, **dadurch gekennzeichnet, dass** bei gleichzeitigem Ansprechen aller Spannungsbegrenzungsvorrichtungen (30, 31, 32) während nur eines Abschaltvorganges eines Stromes durch die Halbleiterschalter ein Signal (Imax) generiert wird, welches einen Halbleiterschalter-Überstrom anzeigt.

13. Verfahren nach einen der Ansprüche 1 bis 11, **dadurch gekennzeichnet, dass** bei Ansprechen aller Spannungsbegrenzungsvorrichtungen (30, 31, 32) im stromlosen Zustand der Halbleiterschalter ein Signal (Umax) generiert wird, welches eine Halbleiterschalter-Überspannung anzeigt.

14. Verfahren nach einem der Ansprüche 1 bis 11, **dadurch gekennzeichnet, daß** zu jedem Halbleiterschalter eine antiparallele Diode (D10, D11, D12) geschaltet wird, wobei bei Ansprechen aller Spannungsbegrenzungsvorrichtungen (30, 31, 32) während einer Stromführung der antiparallelen Dioden der Reihenschaltung ein Signal (Dmax) generiert wird, welches eine Unsymmetrie der antiparallen Dioden anzeigt.

15. Schaltungsanordnung zur Durchführung des Verfahrens nach Anspruch 2, wobei jedem Halbleiterschalter (10, 11, 12) Regelvorrichtungen (100, 101, 102) zugeordnet sind, die zur Modifizierung eines gemeinsamen Steuerimpulses (P1) je eine Verlustleistungs-Erfassungseinrichtung (40) und einen Regler (50) mit einem Impulsverzögerer (60) aufweisen, wobei die Erfassungseinrichtungen (40) während des Schaltvorganges die Verlustleistung der zugeordneten Spannungsbegrenzungsvorrichtungen (30, 31 bzw. 32) messen, die Regler (50) aufgrund der Verlustleistungs-Istwerte eine Verzögerung bilden, die Impulsverzögerer entsprechend dieser Verzögerung den Steuerimpuls verzögern und dadurch den Regelvorrichtungen zugeordnete, modifizierte Steuerimpulse (P20, P21, P22) bilden.

16. Schaltungsanordnung nach Anspruch 15, **dadurch gekennzeichnet, dass** die Erfassungseinrichtungen (40) binäre Istwert-Erfassungseinrichtungen sind, die bei einem während des Ausschaltens auftretenden Stromfluss durch die Spannungsbegrenzungsvorrichtung (30, 31 bzw. 32) pro Ausschaltvorgang einen Impuls (I-Puls) generieren, welcher jeweils durch ein galvanisches Trennelement (80) zu einem digitalen Ausschalt-Regler (501) übertragen wird, der auf einen digitalen Ausschalt-Impuls-Verzögerer (601) wirkt, welcher nach jedem I-Puls die Verzögerung für die Ausschalt-Steuerimpulsflanke um jeweils ein Zeitquantum vergrössert und dadurch einen modifizierten Steuerimpuls (P20, P21 bzw. P22) bildet, welcher durch ein galvanisches Trennelement (81) zum Steuereingang des jeweiligen Halbleiterschalters (10, 11, 12) gelangt.

17. Schaltungsanordnung nach Anspruch 15, **dadurch gekennzeichnet, dass** die Erfassungseinrichtungen (40) eine binäre Istwert-Erfassungseinrichtung sind, die bei einem während des Schaltens auftretenden Stromfluss durch die Spannungsbegrenzungsvorrichtung (30, 31 bzw. 32) pro Schaltvorgang einen Impuls (I-Puls) generieren, welcher jeweils durch ein galvanisches Trennelement (80) zu einer Weiche (41) übertragen wird, die von dem Steuerimpuls (P1) so gesteuert wird, dass die I-Pulse des Einschaltens zu einem digitalen Einschalt-Regler (502) und die I-Pulse des Ausschaltens zu einem digitalen Ausschalt-Regler (501) gelangen, wobei die Ausgänge des Einschalt- (502) bzw. Ausschalt-Reglers (501) auf jeweils einen digitalen Einschalt-Impulsverzögerer (602) und einen digitalen Ausschalt-Impulsverzögerer (601) wirken, durch welchen ein verzögerter Steuerimpuls (P20, P21 bzw. P22) gebildet wird, welcher jeweils durch ein galvanisches Trennelement (81) zum Steuereingang des entsprechenden Halbleiterschalters (10, 11 bzw. 12) gelangt.

18. Schaltungsanordnung nach Anspruch 17, **dadurch gekennzeichnet, dass** ein binäres Spannungsmessglied vorgesehen ist, welches das Unterschreiten eines vorgegebenen Halbleiterschalter Spannungssollwertes nach jedem Ausschalten mit einem Impuls (U-Puls) anzeigt, welcher auf den digitalen Ausschalt-Regler (501) wirkt und zu einer zusätzlichen Verzögerung der Ausschaltflanke führt.

## Claims

1. Method for driving semiconductor switches (10, 11, 12) in a series circuit in which, for equalizing the voltage distribution across the semiconductor switches (10, 11, 12), modified control pulses (P20, P21, P22) for each semiconductor switch (10, 11, 12) are generated by means of a control equipment (110) from a common control pulse (P1) and a measure of a power loss from voltage limiting devices (30, 31, 32) is detected, each semiconductor switch being assigned a respective voltage limiting device (30, 31, 32), **characterized in that** non-latching semiconductor switches are used as semiconductor switches (10, 11, 12), the voltage limiting devices (30, 31, 32) are connected between the collector and control electrode of the respective semiconductor switch (10, 11, 12), and the control equipment (110) modifies the control pulses (P20, P21, P22) for each semiconductor switch (10, 11, 12) in such a manner that the measure of the power loss is controlled to a minimum.

2. Method according to Claim 1, **characterized in that** the control equipment (110) is formed in each case by one control device (100, 101, 102) per semiconductor switch (10, 11, 12).

3. Method according to Claim 1 or 2, **characterized in that** the power loss of the voltage limiting devices (30, 31, 32) is controlled to zero.

4. Method according to one of Claims 1 to 3, **characterized in that** the time integral of the current through each voltage limiting device (30, 31, 32) is used as a measure of its power loss.

5. Method according to one of Claims 1 to 3, **characterized in that** the amplitude of the current through each voltage limiting device (30, 31, 32) is used as a measure of its power loss.

6. Method according to one of Claims 1 to 3, **characterized in that** the duration of the current flow through each voltage limiting device (30, 31, 32) is used as a measure of its power loss.

7. Method according to one of Claims 1 to 3, **characterized in that** the temperature of each voltage limiting device (30, 31, 32) is used as a measure of its power loss.

8. Method according to one of Claims 1 to 7, **characterized in that** the modified control pulses (P20, P21, P22) are formed by time displacement of the switching edges of the control pulse (P1).

9. Method according to one of Claims 1 to 8, **characterized in that** the control equipment (110) or each of the control devices (100, 101, 102), respectively, is digital and a pulse is generated upon the respective voltage limiting device responding and the power loss occurring and the switching edges of the respective modified control pulse (P20, P21, P22) are displaced by one time quantum.

10. Method according to one of Claims 1 to 9, **characterized in that** one semiconductor switch (10) is used as reference switch (master), the switching edges driving it being delayed by a constant time and, based on the measured power loss of the voltage limiting devices (30, 31, 32) of all the semiconductor switches, the switching edges of the remaining semiconductor switches (slaves) (11, 12) are varied in such a way that the power loss of all the semiconductor switches (10, 11, 12) is controlled to a minimum.

11. Method according to one of Claims 1 to 10, **characterized in that** a short-circuit element (90, 91, 92) is in each case connected in parallel with one semiconductor switch (10, 11, 12), so that, in the event of exceeding a response threshold of the short-circuit element, which threshold is higher than the response threshold of the respective voltage limiting device (30, 31, 32), the short-circuit element accepts the current flow from the respective semiconductor switch.

12. Method according to one of Claims 1 to 11, **characterized in that**, in the event of a simultaneous response of all the voltage limiting devices (30, 31, 32) during only one process of switching off a current through the semiconductor switches, a signal (Imax) is generated, which indicates a semiconductor switch overcurrent.

13. Method according to one of Claims 1 to 11, **characterized in that**, in the event of a response of all the voltage limiting devices (30, 31, 32) in the no-current state of the semiconductor switches, a signal (Umax) is generated, which indicates a semiconductor switch overvoltage.

14. Method according to one of Claims 1 to 11, **characterized in that** a diode (D10, D11, D12) is in each case connected in antiparallel with each semiconductor switch, a signal (Dmax) being generated in the event of a response of all the voltage limiting devices (30, 31, 32) during a current supply from the antiparallel diodes of the series circuit, the said signal indicating an asymmetry of the antiparallel diodes.

15. Circuit arrangement for carrying out the method according to Claim 2, in which control devices (100, 101, 102) are assigned to each semiconductor switch (10, 11, 12), which devices, for modifying a common control pulse (P1), have a power loss detection equipment (40) and a controller (50) with a pulse delay unit (60), the detection equipment (40) measuring the power loss of the associated voltage limiting devices (30, 31 or 32, respectively) during the switching process, the controllers (50) forming a delay based on the actual power loss values, the pulse delay unit delaying the control pulse in accordance with this delay and thereby forming the modified control pulses (P20, P21, P22) assigned to the control devices.

16. Circuit arrangement according to Claim 15, **characterized in that** the detection equipment (40) is binary actual value detection equipment which generates a pulse (I-pulse) per switch-off process in the event of a current flow occurring through the voltage limiting device (30, 31 or 32, respectively) during the switching off, the said pulse being transmitted in each case via an electrical isolating element (80) to a digital switch-off controller (501) which acts on a digital switch-off pulse delay unit (601), which increases the delay for the switch-off control pulse edge by one time quantum in each case after each I-pulse and thereby forms a modified control pulse (P20, P21 or P22, respectively), which reaches the control input of the respective semiconductor switch (10, 11, 12) via an electrical isolating element (81).

17. Circuit arrangement according to Claim 15, **characterized in that** the detection equipment (40) is a binary actual value detection equipment which generates a pulse (I-pulse) per switching process in the event of a current flow occurring through the voltage limiting device (30, 31 or 32, respectively) during the switching, the said pulse being transmitted in each case via an electrical isolating element (80) to a switch (41) which is controlled by the control pulse (P1) in such a way that the I-pulses from the switch-on reach a digital switch-on controller (502) and the I-pulses from the switch-off reach a digital switch-off controller (501), the outputs of the switch-on (502) or switch-off (501) controller, respectively, acting respectively on a digital switch-on pulse delay unit (602) and a digital switch-off pulse delay unit (601), by means of which a delayed control pulse (P20, P21 or P22, respectively) is formed, which in each case reaches the control input of the corresponding semiconductor switch (10, 11 or 12, respectively) via an electrical isolating element (81).

18. Circuit arrangement according to Claim 17, **characterized in that** provision is made of a binary voltage measuring element which indicates the undershooting of a prescribed semiconductor switch voltage desired value after each switch-off by means of a pulse (U-pulse) which acts on the digital switch-off controller (501) and leads to an additional delay of the switch-off edge.

## Revendications

1. Procédé pour la commande de commutateurs à semi-conducteur (10, 11, 12) d'un circuit en série, dans lequel; pour l'égalisation de la répartition des tensions entre les commutateurs à semi-conducteur (10, 11, 12), des impulsions de commande (P20, P21, P22) sont créées pour chaque commutateur à semi-conducteur (10, 11, 12) respectif au moyen d'un dispositif de régulation (110) à partir d'une impulsion de commande commune (P1), et une grandeur d'une puissance de perte de dispositifs limiteurs de tension (30, 31, 32) est détectée, un dispositif limiteur de tension (30, 31, 32) étant associé à chaque commutateur à semi-conducteur respectif,
**caractérisé en ce que** comme commutateurs à semi-conducteur (10, 11, 12) on utilise des commutateurs à semi-conducteur sans verrouillage, les dispositifs limiteurs de tension (30, 31, 32) étant raccordés entre le collecteur et l'électrode de commande de chaque commutateur à semi-conducteur (10, 11, 12), et le dispositif de régulation (110) modifiant les impulsions de commande (P20, P21, P22) pour chaque commutateur à semi-conducteur (10, 11, 12) de telle sorte que la grandeur de la puissance de perte soit réglée à un minimum.

2. Procédé selon la revendication 1, **caractérisé en ce que** le dispositif de régulation (110) est formé d'un dispositif de régulation (100, 101, 102) pour chaque commutateur à semi-conducteur (10, 11, 12).

3. Procédé selon la revendication 1 ou 2, **caractérisé en ce que** la puissance de perte des dispositifs limiteurs de tension (30, 31, 32) est réglée à zéro.

4. Procédé selon l'une des revendications 1 à 3, **caractérisé en ce que** comme grandeur de la puissance de perte de chaque dispositif limiteur de tension (30, 31, 32), on utilise l'intégrale du courant qui le traverse.

5. Procédé selon l'une des revendications 1 à 3, **caractérisé en ce que** comme grandeur de la puissance de perte de chaque dispositif limiteur de tension (30, 31, 32), on utilise l'amplitude du courant qui le traverse.

6. Procédé selon l'une des revendications 1 à 3, **caractérisé en ce que** comme grandeur de la puissance de perte de chaque dispositif limiteur de tension (30, 31, 32), on utilise la durée de l'écoulement du courant à travers lui.

7. Procédé selon l'une des revendications 1 à 3, **caractérisé en ce que** comme grandeur de la puissance de perte de chaque dispositif limiteur de tension (30, 31, 32), on utilise sa température.

8. Procédé selon l'une des revendications 1 à 7, **caractérisé en ce que** les impulsions de commande modifiées (P20, P21, P22) sont formées par un décalage temporel des flancs de commutation de l'impulsion de commande (P1).

9. Procédé selon l'une des revendications 1 à 8, **caractérisé en ce que** le dispositif de régulation (110) ou chacun des dispositifs de régulation (100, 101, 102) est numérique, et en cas de réponse de chaque dispositif limiteur de tension et apparition de la puissance de perte, une impulsion est générée et les flancs de commutation de chaque impulsion de commande modifiée (P20, P21, P22) sont déplacés d'un quantum temporel.

10. Procédé selon l'une des revendications 1 à 9, **caractérisé en ce que** l'on utilise comme commutateur de référence (maître) un commutateur à semi-conducteur (10), les flancs de commutation qui le commandent étant retardés d'une durée constante et les flancs de commutation des commutateurs à semi-conducteur restants (esclaves) (11, 12) étant modifiés en fonction de la puissance de perte mesurée sur les dispositifs limiteurs de tension (30, 31, 32) de tous les commutateurs à semi-conducteur, de telle sorte que la puissance de perte de tous les commutateurs à semi-conducteur (10, 11, 12) soit réglée à un minimum.

11. Procédé selon l'une des revendications 1 à 10, **caractérisé en ce qu'**à chaque commutateur à semi-conducteur (10, 11, 12) est raccordé en parallèle un élément de court-circuit (90, 91, 92) respectif, de sorte qu'en cas de dépassement d'un niveau de réponse de l'élément de court-circuit qui est supérieur au niveau de réponse de chaque dispositif limiteur de tension (30, 31, 32) respectif, l'élément de court-circuit reprend l'écoulement du courant provenant de chaque commutateur à semi-conducteur.

12. Procédé selon l'une des revendications 1 à 11, **caractérisé en ce qu'**en cas de réponse simultanée de tous les dispositifs limiteurs de tension (30, 31, 32) pendant une seule opération de débranchement d'un courant à travers les commutateurs à semi-conducteur, un signal (Imax) est généré qui indique un surcourant de commutateur à semi-conducteur.

13. Procédé selon l'une des revendications 1 à 11, **caractérisé en ce qu'**en cas de réponse de tous les dispositifs limiteurs de tension (30, 31, 32) lorsque les commutateurs à semi-conducteur sont à l'état sans courant, un signal (Umax) est généré, qui indique une surtension de commutateur à semi-conducteur.

14. Procédé selon l'une des revendications 1 à 11, **caractérisé en ce que** sur chaque commutateur à semi-conducteur est raccordée une diode antiparallèle (D10, D11, D12), et en cas de réponse de tous les dispositifs limiteurs de tension (30, 31, 32) pendant que du courant traverse les diodes antiparallèles du circuit en série, un signal (Dmax) est généré qui indique une asymétrie des diodes antiparallèles.

15. Agencement de circuit en vue de la mise en oeuvre du procédé selon la revendication 2, dans lequel à chaque commutateur à semi-conducteur (10, 11, 12) sont associés des dispositifs de régulation (100, 101, 102) qui présentent chacun un dispositif (40) de détection de la puissance de perte en vue de la modification d'une impulsion de commande commune (P1) et un régulateur (50) chaque fois doté d'un retardateur d'impulsion (60), les dispositifs de détection (40) mesurant la puissance de perte des dispositifs limiteurs de tension (30, 31 ou 32) pendant l'opération de commutation, les régulateurs (50) formant un retard des valeurs effectives de la puissance de perte, les retardateurs d'impulsion retardant l'impulsion de commande en fonction de ce retard, et formant ainsi des impulsions de commande (P20, P21, P22) associées au dispositif de régulation.

16. Agencement de circuit selon la revendication 15, **caractérisé en ce que** les dispositifs de détection (40) sont des dispositifs de détection binaires de valeur effective qui, en cas d'écoulement d'un courant à travers le dispositif limiteur de tension (30, 31 ou 32) apparaissant pendant le débranchement, génèrent lors de chaque opération de débranchement une impulsion (impulsion I) qui est transférée, chaque fois par un élément de séparation galvanique (80), à un régulateur numérique de débranchement (501) qui agit sur un retardateur numérique d'impulsion de débranchement (601) qui, après chaque impulsion I augmente chaque fois d'un quantum temporel le retard du flanc de l'impulsion de commande de débranchement et forme ainsi une impulsion modifiée de commande (P20, P21 ou P22) qui se rend par l'intermédiaire d'un élément de séparation galvanique (81) vers l'entrée de commande de chaque commutateur à semi-conducteur (10, 11, 12).

17. Agencement de circuit selon la revendication 15, **caractérisé en ce que** les dispositifs de détection (40) sont des dispositifs de détection binaires de valeur effective qui, lors d'un écoulement de courant dans le dispositif limiteur de tension (30, 31, 32) apparaissant pendant le branchement, génèrent lors de chaque opération de commutation une impulsion (impulsion I) qui est transférée, chaque fois par un élément de séparation galvanique (80), à une bascule (41) qui est commandée par l'impulsion de commande (P1) de telle sorte que les impulsions I de branchement se rendent vers un régulateur numérique de branchement (502) et que les impulsions I de débranchement se rendent vers un régulateur numérique de débranchement (501), les sorties du régulateur de branchement (502) et du régulateur de débranchement (501) agissant chaque fois sur un retardateur numérique (602) d'impulsion de branchement et sur un retardateur numérique (601) d'impulsion de débranchement par lesquels sont formées des impulsions de commande retardée (P20, P21 ou P22) qui se rendent, chaque fois par un élément de séparation galvanique (81), vers l'entrée de commande du commutateur à semi-conducteur (10, 11 ou 12) correspondant.

18. Agencement de circuit selon la revendication 17, **caractérisé en ce qu'**un organe de mesure binaire de tension est prévu et indique après chaque débranchement que la valeur prédéterminée de consigne de tension d'un commutateur à semi-conducteur n'est pas atteinte, par une impulsion (impulsion U) qui agit sur le régulateur numérique de débranchement (501) et qui entraîne un retard supplémentaire du flanc de débranchement.
